# EUROPEAN PATENT SPECIFICATION

(11) **EP 0 559 344 B1**
(45) Date of publication and mention of the grant of the patent: **27.08.1997**
(21) Application number: 93301091.0
(22) Date of filing: 16.02.1993
(51) Int. Cl.: H04N 5/50

(54) **Television tuner**
Fernsehtuner
Syntonisateur de récepteur de télévision

(30) Priority: 29.02.1992 KR 337892
(43) Date of publication of application: 08.09.1993
(73) Proprietor: Samsung Electronics Co., Ltd., Suwon-city, Kyungki-do 441-370 (KR)
(72) Inventor: Lee, Nam Hyuk, Suweon, Kyungki-do (KR)
(74) Representative: Read, Matthew Charles

(56) References cited:
- EP-A- 0 455 046
- GB-A- 2 226 722
- US-A- 4 405 947
- US-A- 4 763 195
- US-A- 5 087 977

## Description

The present invention relates to a television signal receiving apparatus for receiving television signals arranged in first and second channelization schemes, the apparatus comprising: a channel selection means; automatic frequency tuning signal generating means for generating an automatic frequency tuning signal; a tuning means responsive to the channel selection means to tune coarsely to a predetermined channel of the first scheme and configured to perform fine tuning, in dependence on the automatic frequency tuning (AFT) signal; and a signal detection means for detecting the synchronizing signal of a television signal tuned in by the tuning means. The present invention also relates to a method of tuning a television signal receiving apparatus having an automatic frequency tuning signal generating means for receiving television signals arranged in first and second channelization schemes, the method comprising the steps of: (a) coarsely tuning to a predetermined channel of the first scheme; (b) detecting the presence of a television signal in the predetermined channel; and (c) fine tuning, on the basis of an automatic frequency tuning signal, until a signal is properly received.

In some cable television systems, the picture carrier frequencies differ from those used in the corresponding channels for wireless distribution. In one cable television system, the picture carrier frequencies are set according to a Harmonically Related Carriers standard. According to this standard, the picture carrier frequency of the US channels, except Channels 5 and 6, are lowered by 1.25MHz relative to the wireless broadcast equivalent. The picture carrier frequencies of US Channels 5 and 6 are higher by 0.75MHZ than the corresponding wireless broadcast channels.

Conventionally, a user operated selection switch is provided on a television receiver to enable the user to select an appropriate tuning mode for the type of signal to be received.

A television signal receiving apparatus is known from US-A-4823387 which comprises a channel selection means, a tuning means responsive to the channel selection means to tune coarsely to a channel, and a signal detection means for detecting a signal tuned by the tuning means, wherein on coarsely tuning to a channel, the tuning means performs fine tuning.

This arrangement avoids the need for a mode selection switch to be incorporated into a television receiver, thus avoiding the attendant manufacturing cost penalty. However, it typically takes approximately 500 to 900 milliseconds for a Harmonically Related Carrier standard signal to be correctly tuned. During this period, an unpleasant noise is generated by the television receiver.

A similar problem exists with regard to the reception of signals according to the Interval Related Carrier standard.

It is an aim of the present invention to overcome these problems.

Background prior art useful for understanding the present invention is disclosed in US-A-4763195, US-A-5087977 and EP-A-0455046.

According to the present invention, there is provided a television signal receiving apparatus of the type defined above characterised in that the tuning means is configured to perform a predetermined tuning shift to a corresponding channel of the second scheme in response to no detection of a synchronizing signal by the signal detecting means in said predetermined channel and to perform said fine tuning immediately, in response to detection of a synchronizing signal by the signal detecting means in said predetermined channel, and after performing said predetermined tuning shift, in response to no detection of a synchronizing signal by the signal detecting means in said predetermined channel.

Preferably, the tuning means comprises a microprocessor and a tuner.

Preferably, the channel selection means comprises user input means.

In a preferred embodiment, if a synchronizing signal is detected in the predetermined channel, the fine tuning is performed either up, within a frequency range of 2MHz, or down, within a frequency range of 0.5MHz, in dependence on the AFT signal and if a synchronizing signal is not detected in the predetermined channel, the fine tuning is performed either up or down, within a frequency range of 0.75MHz, in dependence on the AFT signal.

The present invention also provides a method of the above-defined type, characterised in that step (b) comprises detecting the presence of a television signal from the presence of a television synchronizing signal and step (c) is performed immediately a synchronizing signal is detected at step (b) and after a predetermined tuning shift to a corresponding channel of the second scheme if no synchronizing signal is detected at step (b).

In a preferred embodiment, if a synchronizing signal is detected at step (b), the fine tuning is performed either up, within a frequency range of 2MHz, or down, within a frequency range of 0.5MHz, in dependence on the AFT signal and if a synchronizing signal is not detected at step (b), the fine tuning is performed either up or down, within a frequency range of 0.75MHz, in dependence on the AFT signal.

By means of the present invention, the time for correctly tuning a Harmonically Related Carrier signal can be reduced to approximately 100 milliseconds thereby avoiding the unpleasant noise associated with the prior art.

An embodiment of the present invention will now be described, by way of example, with reference to the accompanying drawings, in which:
Figure 1 is a schematic block diagram showing the composition of a television receiver embodying the present invention; and
Figures 2A and 2B are flow charts showing the operational principle of the receiver shown in Figure 1.

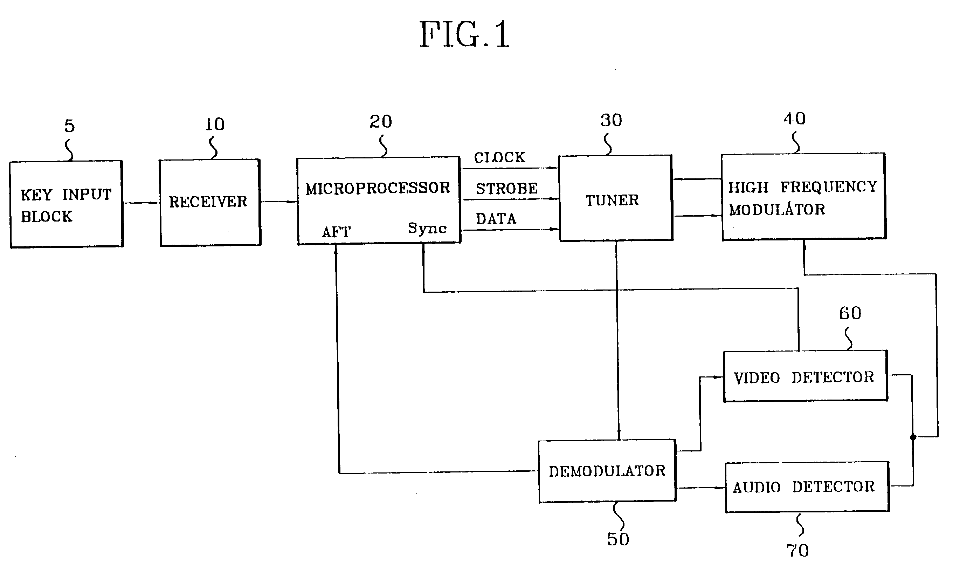

Referring to Figure 1, a television receiver comprises a key input block 5 consisting of a remote controller or a key panel; a receiver 10 for receiving the output signals from the key input block 5; a microprocessor 20 connected to the receiver 10, for controlling the whole system; a tuner 30 connected to the microprocessor 20, for tuning the receiver according to a clock signal and data from the microprocessor 20; a high frequency modulator 40 connected to the tuner 30, for high frequency modulating the tuned signal; a demodulator 50 connected to the tuner 30, for demodulating the tuned signal by intermediate frequency processing and for feeding an automatic fine tuning (AFT) signal produced by an automatic fine tuning detector (not shown in the drawing) to the microprocessor 20; a video detector 60 connected to the demodulator 50, for sending a detection signal to the microprocessor 20 when a video signal is detected in the demodulated signal; and an audio detector 70 connected to the demodulator 50, for detecting audio signals in the demodulated signals.

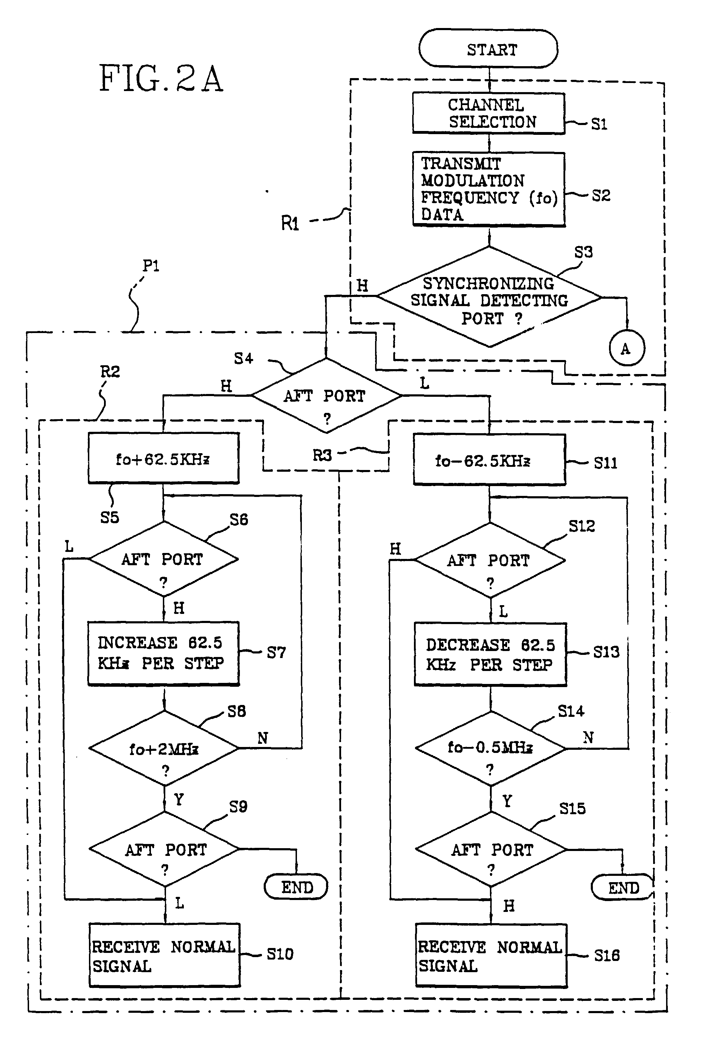

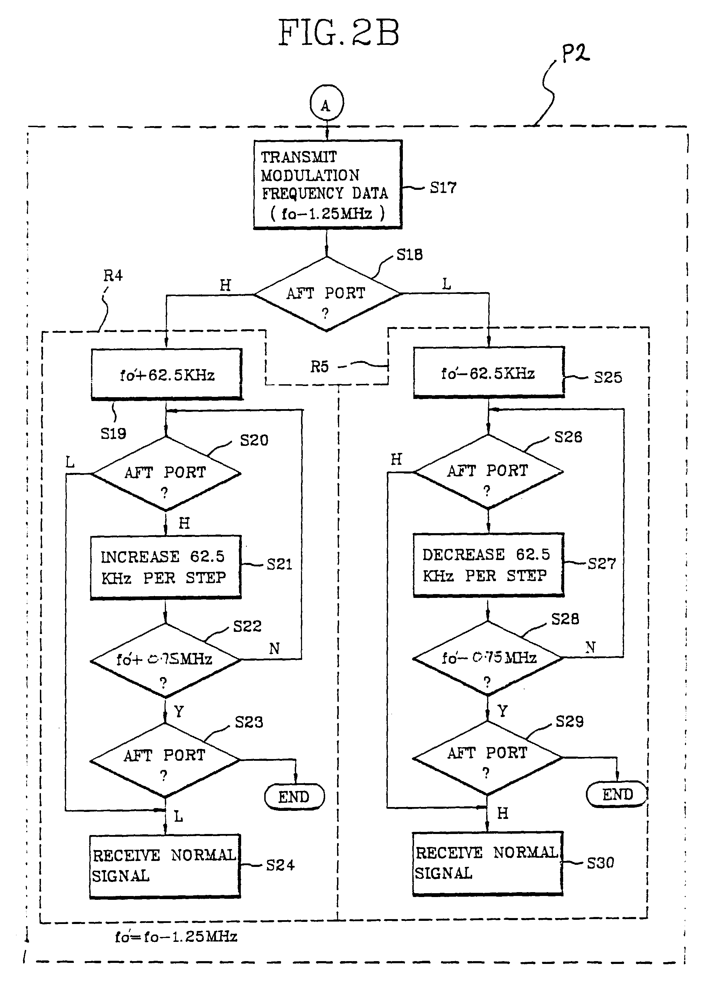

Figure 2A is a procedure for a standard (STD) mode of reception and Figure 2B is a procedure for a Harmonically Related Carrier (HRC) mode of reception. More specifically, the desired implementation of the present invention consists of an initial routine R1, an STD mode reception procedure P1, and an HRC mode reception procedure P2.

The initial routine R1 in Figure 2A further comprises a selecting step S1 for selecting a channel through the key input block 5; a transmitting step S2 for transmitting tuning frequency (fo) data to a PLL (Phase Locked Loop) IC (not shown in the drawing) for selecting channels, of the tuner 30 when a channel has been selected; and a determining step S3 for determining the presence of a synchronizing signal by checking the video signal demodulated by the demodulator 50.

The STD mode reception procedure P1 is executed when it is determined that an STD mode signal is being broadcast, i.e. that there exists a video signal within +2MHz and -0.5MHz of the tuning frequency (fo) based upon the detection of a high state at the synchronizing detection port (indicating that a synchronizing signal is detected), and further comprises a determining step S4 wherein a routine R2 is caused to be executed when the AFT port is high and a routine R3 is caused to be executed when the AFT port is low.

The routine R2 comprises an incrementing step S5 for increasing the tuning frequency (fo) by a step of 62.5kHz when the AFT port is determined to be high by the determining step S4, and a determining step S6 for checking the state of the AFT port after every increase in the tuning frequency (fo) by the incrementing step S5; an incrementing step S7; a determining step S8 for determining whether the tuning frequency (fo) has been increased by 2MHz; a determined step S9 to check the AFT port, if the increased portion has not reached 2 MHz, and a reception step S10 for terminating the AFT operation after transmitting the tuning frequency, if the state of the AFT port remains high, and for beginning reception of a standard signal, if the AFT port changes its state to low.

The routine R3 comprises a decrementing step S11 for decreasing the tuning frequency (fo) by a step of 62.5kHz when the AFT port is determined to be low by the determining step S4; a determining step S12 for checking the AFT port after every decrease of tuning frequency by the decrementing step S11; a decrementing step S13; a determining step S14 for determining whether the tuning frequency has decreased by 0.5MHz; a determining step S15 for directly checking the AFT port without returning to the determining step S12 if the tuning frequency has decreased by 0.5MHz; and a reception step S16 for terminating the AFT operation after transmitting the tuning frequency, if the state of the AFT port remains low, and for beginning reception of a standard signal if the AFT port changes its state to high.

The HRC mode reception procedure P2 in Figure 2B is executed when no synchronizing signal is detected at the determining step S3, and comprises a transmitting step S17 for transmitting a tuning frequency (fo' = fo - 1.25MHz); a determining step S18 for checking the state of the AFT port; a routine R4 being executed when the AFT port is high; and a routine R5 being executed when the AFT port is low.

The routine R4 comprises an incrementing step S19 for increasing the tuning frequency (fo') by a step of 62.5kHz when the AFT port is determined to be high by the determining step S18; and a determining step S20 for checking the state of the AFT port after every increase in the tuning frequency (fo'); an incrementing step S21 for increasing the tuning frequency again when the state of the AFT port is high; a determining step S22 for determining whether the tuning frequency (fo) has increased by 0.75MHz; a determining step S23 for returning to the determining step S20 to check the AFT port, if the timing frequency (fo') has not been increased by 0.75MHz; and a reception step S24 for terminating the AFT operation after transmitting the tuning frequency, if the state of the AFT port remains high, interpreting the high state as absence of a broadcast signal, and for beginning reception of an HRC signal, if the AFT port changes its state to low.

The routine R5 comprises a decrementing step S25 for decreasing the tuning frequency (fo') by a step of 62.5kHz when the AFT port is determined to be low by the determining step S18; a determining step S26 for checking the AFT port after every decrease of the tuning frequency; a decrementing step S27 for further decreasing the tuning frequency by a step of 62.5kHz, if the AFT port remains low; a determining step S28 for determining whether the tuning frequency has decreased by 0.75MHz; a determining step S29 for returning to the determining step S26 to check the AFT port, if the tuning frequency has not been decreased by 0.75MHz; and a reception step S30 for terminating the AFT operation after transmitting the tuning frequency, if the state of the AFT port remains low, and for beginning reception of an HRC signal, if the AFT port changes its state to high.

The operation of the embodiment, described above, will now be described, referring to the tuning frequency of the STD mode as fo and that of the HRC mode as fo' (= fo - 1.25MHz). Selection step S1 is performed first to select a channel using the key input block, and in step S2, tuning frequency (fo) data of the selected channel is output to the PLL IC of the tuner 30 for channel selection.

In step S3, the presence of a video synchronizing signal is determined after the video detector 60 detects video signals demodulated by the demodulator 50. The presence of the video synchronizing signal can be determined by checking the output of the synchronizing detection port of the video block inside the television receiver. If the output is high, it can be assumed that standard mode signals are being broadcast since there must be video signals within -0.5MHz and +2MHz of the tuning frequency (fo). This is made possible by suitably designing the intermediate frequency characteristic of the tuner 30. Therefore, if the synchronizing detection port is high, determining step S4 is performed to check the AFT port. If the AFT port is high, the tuning frequency is increased by a step of 62.5kHz, and this checking and increasing is repeated until the tuning frequency has been increased by 2MHz or the AFT port changes its state from high to low whereupon the tuning frequency at that time is considered to be the correct frequency and the increase in tuning frequency is stopped and the signals are received normally.

If the tuning frequency has been increased by less than 2MHz, the incrementing step S6 is performed again to increase the tuning frequency by a further step. This is repeated until the AFT port changes its state to low. However, if the tuning frequency has been increased by 2MHz in the determining step S8, determining step S9 is performed to check the AFT port.

If the AFT port is still high, it is considered that there are no broadcasting signals, and the AFT operation is terminated while transmitting the tuning frequency (fo). If the AFT port changes its state to low, it is considered to be the correct tuning point and the reception step S10 is performed.

If the synchronizing signal detection port is high in the determining step S3 and if the AFT port is low in the determining step S4, the tuning frequency is decreased by a step of 62.5kHz until it has been decreased by 0.5MHz, while the AFT port is checked after every decrement.

More specifically, if the AFT port is high in determining step S4, a decrementing step S11 is performed to decrease the tuning frequency by a step of 62.5kHz and then determining step S12 is performed to check the AFT port again. If at determining step S12 the AFT port has changed to high, it is considered to be at the correct tuning point and the reception step S16 is performed. If the AFT port is still low, decreasing step S13 is performed again to decrease the modulation frequency by a step of 62.5kHz and the determining step S14 determines whether the tuning frequency has been decreased by 0.5MHz.

If the tuning frequency has been decreased by less than 0.5 MHz, the determining step S12 and the decrementing step S13 are performed again to decrease the tuning frequency by a step, and this is repeated until the AFT port changes its state to high. If it is determined that the tuning frequency has been decreased by 0.5MHz in the determining step S14, determining step S15 is performed to check the AFT port.

If in the determining step S15 the AFT port is still low, it is assumed that there are no broadcasting signals, and the AFT operation is terminated while transmitting the tuning frequency (fo). If the AFT port changes it state to high, it is considered that the correct tuning point has been reached and the reception step S15 is performed.

Meanwhile, if no synchronizing signal is detected in the determining step S3, it is assumed that the selected channel does not contain a STD mode broadcast signal but an HRC mode one, and the transmitting step S17 is performed to transmit the tuning frequency (fo' = fo - 1.25 MHz) data for the HRC mode. After this, the AFT port is checked and if its state is high, the tuning frequency is increased by a step of 62.5kHz until it has been increased by 0.75 MHz while the AFT port is checked after every such increase.

More specifically, if the AFT port is determined to be high in the determining step S18 the tuning frequency (fo') is increased by a step and the AFT port is again checked in the determining step S20. If the AFT port changes its state to low, it is considered that the correct tuning point has been found and the reception step S24 is performed. If the AFT port is still high, incrementing step S21 is performed to increase the tuning frequency (fo') by a step and the determining step S22 determines whether it has been increased by 0.75MHz, or whether the tuning frequency (fo') has reached fo' + 0.75MHz. If the increase is less than 0.75MHz, the incrementing step S20 is performed again to increase the tuning frequency (fo') by a step, and this is repeated until the AFT port changes its state to low. However, if the increase is equal to 0.75MHz at the determining step S22, making the tuning frequency fo' + 0.75MHz, determining step S23 is performed to check the AFT port.

If at determining step S23 the AFT port is still high, it is assumed that there are no broadcasting signals, and the AFT operation is terminated while transmitting the tuning frequency (fo). If the AFT port changes its state to low, it is considered that the correct tuning point has been found and the reception step S24 is performed.

Meanwhile, if the AFT port is determined to be low by the determining step S18, the decrementing step S25 is performed again to decrease the tuning frequency (fo') by a step, and the determining step S26 is performed to check the AFT port. If the AFT port changes its state to high, it is considered that the correct tuning point has been found and the reception step S30 is performed. If the AFT port is still low, decrementing step S27 is performed to decrease the tuning frequency (fo') by a step and the determining step S28 determines whether the decrease has reached 0.75MHz, or whether the tuning frequency (fo) has reached fo' - 0.75MHz.

If the decrease is less than 0.75MHz, the decrementing step S26 is performed again to decrease the tuning frequency (fo') by a step, until the AFT port changes its state to high. However, if the decrease is equal to 0.75MHz at the determining step S28, that is the tuning frequency = fo' - 0.75MHz, determining step S29 is performed to check the AFT port.

If at determining step S29 the AFT port is still low, it is assumed that there are no broadcasting signals, and the AFT operation is terminated while transmitting the tuning frequency (fo'). If the AFT port changes its state to high, it is considered that the correct tuning point has been found and the reception step S30 is performed.

As described above, the present invention has the effect of improving the quality of the television receiver or video cassette recorder without a cable mode (STD, HRC and IRC) selection switch, by preventing the generation of unpleasant noises through a reduction of the HRC or IRC mode reception time. This is achieved by detecting the presence of a synchronizing signal when a channel is selected to determine whether the broadcasting signals are in STD mode or a non-standard mode in advance of normal signal reception, therefore eliminating the waiting time and reducing the reception time in for HRC signals to only about 100ms.

## Claims

1. A television signal receiving apparatus for receiving television signals arranged in first and second channelization schemes, the apparatus comprising:
a channel selection means (5, 10);
automatic frequency tuning signal generating means for generating an automatic frequency tuning signal;
a tuning means (20, 30) responsive to the channel selection means (5, 10) to tune coarsely to a predetermined channel of the first scheme and configured to perform fine tuning, in dependence on the automatic frequency tuning signal; and
a signal detection means (50, 60) for detecting the synchronizing signal of a television signal tuned in by the tuning means (5, 10),
**characterised in that** the tuning means (20, 30) is configured to perform a predetermined tuning shift to a corresponding channel of the second scheme in response to no detection of a synchronizing signal by the signal detecting means (50, 60) in said predetermined channel and to perform said fine tuning immediately, in response to detection of a synchronizing signal by the signal detecting means (50, 60) in said predetermined channel, and after performing said predetermined tuning shift, in response to no detection of a synchronizing signal by the signal detecting means (50, 60) in said predetermined channel.

2. An apparatus according to claim 1, wherein the tuning means (20, 30) comprises a microprocessor (20) and a tuner (30).

3. An apparatus according to claim 1 or 2, wherein the channel selection means (5, 10) comprises user input means (5, 10).

4. An apparatus according to claim 1, 2 or 3, wherein:
if a synchronizing signal is detected in the predetermined channel, the fine tuning is performed either up, within a frequency range of 2MHz, or down, within a frequency range of 0.5MHz, in dependence on the automatic frequency tuning signal; and
if a synchronizing signal is not detected in the predetermined channel, the fine tuning is performed either up or down, within a frequency range of 0.75MHz, in dependence on the automatic frequency tuning signal.

5. A method of tuning a television signal receiving apparatus having an automatic frequency tuning signal generating means for receiving television signals arranged in first and second channelization schemes, the method comprising the steps of:
(a) coarsely tuning to a predetermined channel of the first scheme;
(b) detecting the presence of a television signal in the predetermined channel; and
(c) fine tuning, on the basis of an automatic frequency tuning signal, until a signal is properly received, **characterised in that** step (b) comprises detecting the presence of a television signal from the presence of a television synchronizing signal and step (c) is performed immediately a synchronizing signal is detected at step (b) and after a predetermined tuning shift to a corresponding channel of the second scheme if no synchronizing signal is detected at step (b).

6. A method according to claim 5, wherein:
if a synchronizing signal is detected at step (b), the fine tuning is performed either up, within a frequency range of 2MHz, or down, within a frequency range of 0.5MHz, in dependence on the automatic frequency tuning signal; and
if a synchronizing signal is not detected at step (b), the fine tuning is performed either up or down, within a frequency range of 0.75MHz, in dependence on the automatic frequency tuning signal.

## Patentansprüche

1. Fernsehsignal-Empfangsgerät zum Empfangen von Fernsehsignalen, die in einem ersten und einem zweiten Kanalschema angeordnet sind, wobei das Gerät folgendes aufweist:
eine Kanalauswahleinrichtung (5, 10);
eine Automatikfrequenzeinstellsignal-Erzeugungseinrichtung zum Erzeugen eines Automatikfrequenzeinstellsignals;
eine Einstelleinrichtung (20, 30), die auf die Kanalauswahleinrichtung (5, 10) antwortet, um einen vorbestimmten Kanal des ersten Schemas grob einzustellen, und die derart aufgebaut ist, daß sie eine Feineinstellung in Abhängigkeit vom Automatikfrequenzeinstellsignal durchführt; und
eine Signalerfassungseinrichtung (50, 60) zum Erfassen des Synchronisiersignals eines durch die Einstelleinrichtung (5, 10) eingestellten Fernsehsignals,
**dadurch gekennzeichnet, daß** die Einstelleinrichtung (20, 30) derart aufgebaut ist, daß sie eine vorbestimmte Einstellverschiebung zu einem entsprechenden Kanal des zweiten Schemas in Antwort auf keine Erfassung eines Synchronisiersignals durch die Signalerfassungseinrichtung (50, 60) im vorbestimmten Kanal durchführt, und die Feineinstellung in Antwort auf eine Erfassung eines Synchronisiersignals durch die Signalerfassungseinrichtung (50, 60) im vorbestimmten Kanal und nach einem Durchführen der vorbestimmten Einstellverschiebung in Antwort auf keine Erfassung eines Synchronisiersignals durch die Signalerfassungseinrichtung (50, 60) im vorbestimmten Kanal sofort durchführt.

2. Gerät nach Anspruch 1, wobei die Einstelleinrichtung (20, 30) einen Mikroprozessor (20) und einen Tuner (30) aufweist.

3. Gerät nach Anspruch 1 oder 2, wobei die Kanalauswahleinrichtung (5, 10) eine Benutzereingabeeinrichtung (5, 10) aufweist.

4. Gerät nach Anspruch 1, 2 oder 3, wobei
dann, wenn ein Synchronisiersignal im vorbestimmten Kanal erfaßt wird, die Feineinstellung in Abhängigkeit vom Automatikfrequenzeinstellsignal entweder nach oben innerhalb eines Frequenzbereichs von 2 MHz oder nach unten innerhalb eines Frequenzbereichs von 0,5 Mhz durchgeführt wird; und
dann, wenn kein Synchronisiersignal im vorbestimmten Kanal erfaßt wird, die Feineinstellung in Abhängigkeit vom Automatikfrequenzeinstellsignal entweder nach oben oder nach unten innerhalb eines Frequenzbereichs von 0,75 MHz durchgeführt wird.

5. Verfahren zum Einstellen eines Fernsehsignal-Empfangsgeräts mit einer Automatikfrequenzeinstellsignal-Erzeugungseinrichtung zum Empfangen von Fernsehsignalen, die in einem ersten und einem zweiten Kanalisationsschema angeordnet sind, wobei das Verfahren folgende Schritte aufweist:
(a) grobes Einstellen auf einen vorbestimmten Kanal des ersten Schemas;
(b) Erfassen des Vorhandenseins eines Fernsehsignals im vorbestimmten Kanal; und
(c) Feineinstellen auf der Basis eines Automatikfrequenzeinstellsignals, bis ein Signal geeignet empfangen wird,
**dadurch gekennzeichnet, daß** der Schritt (b) ein Erfassen des Vorhandseins eines Fernsehsignals aus dem Vorhandensein eines Fernsehsynchronisiersignals aufweist, und der Schritt (c) sofort durchgeführt wird, wenn beim Schritt (b) ein Synchronisiersignal erfaßt wird, und nach einer vorbestimmten Einstellverschiebung zu einem entsprechenden Kanal des zweiten Schemas, wenn beim Schritt (b) kein Synchronisiersignal erfaßt wird.

6. Verfahren nach Anspruch 5, wobei
dann, wenn beim Schritt (b) ein Synchronisiersignal erfaßt wird, die Feineinstellung in Abhängigkeit vom Automatikfrequenzeinstellsignal entweder nach oben innerhalb eines Frequenzbereichs von 2 MHz oder nach unten innerhalb eines Frequenzbereichs von 0,5 MHz durchgeführt wird; und
dann, wenn beim Schritt (b) kein Synchronisiersignal erfaßt wird, die Feineinstellung in Abhängigkeit vom Automatikfrequenzeinstellsignal entweder nach oben oder nach unten innerhalb eines Frequenzbereichs von 0,75 MHz durchgeführt wird.

## Revendications

1. Appareil de réception de signaux de télévision conçu pour recevoir des signaux de télévision présents dans des premier et second systèmes de formation de canaux, l'appareil comprenant :
des moyens (5,10) de sélection de canaux;
des moyens de production de signal de syntonisation de fréquence automatique pour produire un signal de syntonisation de fréquence automatique;
des moyens de syntonisation (20,30) aptes à répondre aux moyens (5,10) de sélection de canaux pour réaliser une syntonisation approximative sur un canal prédéterminé du premier système, et configurés de manière à réaliser une syntonisation précise en fonction du signal de syntonisation de fréquence automatique; et
des moyens (50,60) de détection de signal pour détecter le signal de synchronisation d'un signal de télévision syntonisé par les moyens de syntonisation (5,10),
caractérisé en ce que les moyens de syntonisation (20,30) sont configurés de manière à exécuter un décalage de syntonisation prédéterminé sur un canal correspondant du second système en réponse à l'absence de détection du signal de synchronisation par les moyens (50,60) de détection de signal dans ledit canal prédéterminé, et exécuter immédiatement ladite syntonisation précise en réponse à la détection d'un signal de synchronisation par les moyens (50,60) de détection de signal dans ledit canal prédéterminé, et après exécution dudit décalage de syntonisation prédéterminé, en réponse à l'absence de détection d'un signal de synchronisation par les moyens (50,60) de détection de signal dans ledit canal prédéterminé.

2. Appareil selon la revendication 1, dans lequel les moyens de syntonisation (20,30) comprennent un microprocesseur (20) et un syntoniseur (30).

3. Appareil selon la revendication 1 ou 2, dans lequel les moyens (5,10) de sélection de canal comprennent des moyens d'entrée d'utilisateur (5,10).

4. Appareil selon la revendication 1, 2 ou 3, dans lequel :
si un signal de synchronisation est détecté dans le canal prédéterminé, la syntonisation précise est exécutée dans le sens croissant, avec une gamme de fréquences de 2 MHz, ou dans le sens décroissant avec une gamme de fréquences de 0,5 MHz, en fonction du signal de syntonisation de fréquence automatique; et
si un signal de synchronisation n'est pas détecté dans le canal prédéterminé, la syntonisation précise est exécutée dans le sens croissant ou dans le sens décroissant, dans une gamme de fréquences de 0,75 MHz, en fonction du signal de syntonisation de fréquence automatique.

5. Procédé de syntonisation d'un appareil de réception de signaux de télévision comportant des moyens de production de signal de syntonisation de fréquence automatique pour recevoir des signaux de télévision disposés dans des premier et second systèmes de formation de canaux, le procédé comprenant les étapes consistant à :
(a) syntoniser de façon approximative un canal prédéterminé du premier système;
(b) détecter la présence d'un signal de télévision dans le canal prédéterminé, et
(c) effectuer une syntonisation précise sur la base d'un signal de syntonisation de fréquence automatique jusqu'à ce qu'un signal soit correctement reçu,
caractérisé en ce que l'étape (b) comprend la détection de la présence d'un signal de télévision à partir de la présence d'un signal de synchronisation de télévision, et l'étape (c) est exécutée immédiatement lorsqu'un signal de synchronisation est détecté à l'étape (b), et après un transfert de syntonisation prédéterminé à un canal correspondant du second système si aucun signal de synchronisation n'est détecté lors de l'étape (b).

6. Procédé selon la revendication 5, dans lequel :
si un signal de synchronisation est détecté à l'étape (b), la syntonisation précise est exécutée dans le sens montant, dans une gamme de fréquences de 2 MHz, ou dans le sens descendant, dans une gamme de fréquences de 0,5 MHz, en fonction du signal de syntonisation de fréquence automatique; et
si un signal de synchronisation n'est pas détecté à l'étape (b), la syntonisation précise est exécutée dans le sens montant ou dans le sens décroissant, dans une gamme de fréquences de 0,75 MHz, en fonction du signal de syntonisation de fréquence automatique.
